(19) Europäisches Patentamt
European Patent Office
Office européen des brevets

(11) **EP 4 439 088 A1**

(12) **EUROPÄISCHE PATENTANMELDUNG**

(43) Veröffentlichungstag:
**02.10.2024 Patentblatt 2024/40**

(21) Anmeldenummer: **24166201.4**

(22) Anmeldetag: **26.03.2024**

(51) Internationale Patentklassifikation (IPC):
*G01R 15/20* (2006.01)     *G01R 35/00* (2006.01)

(52) Gemeinsame Patentklassifikation (CPC):
**G01R 35/00; G01R 15/207**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(30) Priorität: **31.03.2023   DE 102023108347**

(71) Anmelder:
• **Göpel electronic GmbH
07745 Jena (DE)**

• **Sensitec GmbH
35578 Wetzlar (DE)**

(72) Erfinder:
• **HAUBOLD, Sven
07745 Jena (DE)**
• **BRUSIUS, Matthias
35080 Bad Endbach (DE)**
• **KNOLL, Heiko
35037 Marburg (DE)**

(74) Vertreter: **Gleim Petri Patent- und
Rechtsanwaltspartnerschaft mbB
Neugasse 13
07743 Jena (DE)**

(54) **VORRICHTUNG UND VERFAHREN ZUR AUSFALLFRÜHERKENNUNG EINES MAGNETFELDSENSITIVEN STROMSENSORS**

(57)    Die Erfindung betrifft eine Vorrichtung und ein Verfahren zum Erkennen einer fehlerfreien Arbeitsweise mit einer magnetfeldüberwachten Stromschiene oder Leiterschleife zur Strommessung auf Basis eines magnetfeldsensitiven Sensorelements. Erfindungsgemäß wird die Aufgabe des Erkennens fehlerhafter Arbeitsweise eines magnetfeldsensitiven Stromsensors (1), umfassend eine in einer Messebene (11) des Stromsensors (1) ausgebildete Stromschiene oder Leiterschleife (2), die mindestens in einem Messbereich (12) durch den Stromsensor (1) auf Basis eines magnetfeldsensitiven Effekts abtastbar ist, dadurch gelöst, dass in räumlicher Nachbarschaft zu der vom Stromsensor (1) abgetasteten Leiterschleife (2) eine Testleiterschleife (3) angeordnet ist, wobei die Testleiterschleife (3) in einer zur Messebene (11) der abgetasteten Leiterschleife (2) parallelen Ebene angeordnet und an einen von der Leiterschleife (2) vorgegebenen Hauptstrompfad (21) so angepasst ist, dass ein in die Testleiterschleife (3) eingeleiteter modulierter Teststrom ($I_T$) im Messbereich (12) des Stromsensors (1) zusammen mit einem Strom im Hauptstrompfad (21) magnetfeldsensitiv abtastbar ist.

**Fig. 4**

EP 4 439 088 A1

**Beschreibung**

Die Erfindung betrifft eine Vorrichtung und ein Verfahren zum Erkennen einer fehlerfreien Arbeitsweise eines Stromsensors auf Basis eines magnetfeldsensitiven Sensorelementes, das bevorzugt als Gradientensensor aufgebaut ist, umfassend eine in einer Messebene des Stromsensors ausgebildete Stromschiene oder Leiterschleife, insbesondere zur Früherkennung von Ausfallerscheinungen von Stromsensoren in sicherheitsrelevanten Bereichen, vorzugsweise in der Leistungselektronik von Elektroantrieben, beispielsweise in Automobilen mit Elektroantrieb.

Aus dem Stand der Technik sind verschiedene Verfahren zum Prüfen bzw. Erkennen der fehlerhaften Messung von magnetfeldsensitiven Stromsensoren bekannt, die aber entweder mit mehreren Stromsensoren redundant arbeiten oder für eine Plausibilitätstestphase einen stromlosen Hauptstrompfad oder mindestens eine stromlose abzutastende Leiterschleife benötigen. Andere Messsysteme, die auf Verwendung von Zusatzwicklungen auf ferromagnetischen Kernen basieren, sind sehr platzintensiv, träge und benötigen meist eine mechanische Durchführung des Hauptstromleiters durch den ferromagnetischen Kern, der den Hauptstrom nicht unbeeinflusst lässt. Bei einfachen Shunt-Messsystemen fehlt die galvanische Trennung und es treten zusätzliche energetische Verluste am Shunt auf.

So wird beispielsweise in der DE 10 2012 215 946 A1 der zu messende Strom über einen (ohmschen) Shunt-Widerstand geführt und der sich einstellende Spannungsabfall gemessen. Durch einen zweiten, parallel geschalteten Widerstand wird ein zusätzlicher definierter Stromfluss erzeugt, der zum Differenzstromtest verwendet werden kann. Durch den Einsatz von Shunt-Widerständen fallen zusätzliche Verluste, z.B. in Form von Wärme an, die bei entsprechenden großen Strömen durchaus problematisch sein können. Wegen nicht vorhandener galvanischer Trennung muss das Messsystem für alle möglichen auftretenden Spannungen und Ströme ausgelegt sein.

Aus der US 2012/0319473 A1 ist beispielsweise ein Stromsensor zum Messen der durch die stromführenden Leiter verursachten Magnetfelder bekannt, bei dem der stromdurchflossene Leiter von einem Kernmaterial umschlossen ist, auf dem zur induktiven Einprägung eines Teststroms zusätzliche Windungen sowie auch die eigentliche Strom-Messspule angebracht sind. Dadurch ist der Stromsensor selbst nicht ohne Weiteres abtrennbar. Zusätzlich muss das in den Testwicklungen erzeugte Testmagnetfeld so hoch bemessen werden, dass der Differenzstrom auch sicher detektiert werden kann. D.h. die Strommessung ist nur für sehr hohe Ströme ausgelegt und sehr unempfindlich, sodass der eingeprägte Teststrom auch einen ausreichend hohen Betrag aufweisen muss, um sicher detektiert zu werden.

Weiterhin ist aus der WO 2006/042839 A1 ein Verfahren zur Messung eines externen magnetischen Feldes bekannt mit einem magnetoresistiven Sensor, einem Generatormodul zum Erzeugen eines zusätzlichen Feldes im Bereich, der den magnetoresistiven Sensor enthält, und mit einer Steuereinheit, die in einem ersten Schritt das Generatormodul so steuert, um einen zusätzlichen Magnetfeldimpuls anzuwenden mit einem ersten Wert einer ersten Polarität und Stärke, die den magnetoresistiven Sensor sättigt, und die in einem zweiten Schritt einen zweiten Wert des zusätzlichen Magnetfeldes anwendet, der den Sensor nicht sättigt, um dann den Wert des zu messenden externen Magnetfeldes durch Widerstandsmessung mit dem magnetoresistiven Sensor zu bestimmen. Bevorzugt wird dabei der erste Schritt in situ vor jeder Messung des externen Magnetfeldes ausgeführt, um jegliche Drift der Sensorempfindlichkeit systematisch und genau zu korrigieren.

Ferner ist in der EP 1 327 891 B1 ein Magnetfeldsensor und ein Strommesser beschrieben, wobei auf einem Substrat relativ zu einer Hauptsubstratebene Strukturen als schräge oder senkrechte Wände vorhanden sind, die vorzugsweise als Gräben oder als Erhebungen zur Erzeugung unterschiedlich ausgerichteter magnetfeldsensitiver Schichten unter verschiedenen Winkeln ausgebildet sind. Ein in derartiger Weise ausgestatteter Magnetfeldsensor wird dann in einem Stromsensor derart verwendet, dass die magnetische Wirkung des Stromflusses in einem Leiter am Ort des vorgestellten Magnetfeldsensors zur Ermittlung der Stromstärke verwendet wird.

Der Erfindung liegt die Aufgabe zugrunde, eine neuartige Möglichkeit zum Erkennen einer fehlerfreien Arbeitsweise von Stromsensoren mit magnetfeldsensitiver Abtastung zu finden, mit der in einer abzutastenden Stromschiene oder Leiterschleife der magnetfeldsensitiv gemessene Hauptstrompfad regelmäßig oder spontan bei ununterbrochenem Stromfluss (in situ) überprüft werden kann, ohne dass der gemessene Stromfluss in der abzutastenden Stromschiene oder Leiterschleife beeinflusst, verfälscht oder gar zeitweise unterbrochen wird. Ferner soll ein Verfahren zum Prüfen der fehlerfreien Arbeitsweise von Stromsensoren mit magnetischer Abtastung bereitgestellt werden, das eine frühzeitige Erkennung von Ausfallerscheinungen gestattet.

Erfindungsgemäß wird die Aufgabe bei einer Vorrichtung zum Erkennen einer fehlerhaften Arbeitsweise eines Stromsensors auf Basis eines magnetfeldsensitiven Sensorelements, das bevorzugt als Gradientensensor ausgebildet ist, umfassend eine in einer Messebene des Stromsensors ausgebildete abgetastete Stromschiene oder Leiterschleife, die mindestens in einem Messbereich durch den Stromsensor abtastbar ist, dadurch gelöst, dass in räumlicher Nachbarschaft zu der vom Stromsensor abzutastenden Stromschiene oder Leiterschleife eine Testleiterschleife angeordnet ist, wobei die Testleiterschleife in einer zur Messebene der abgetasteten Stromschiene oder Leiterschleife parallelen Ebene angeordnet und an einen von der Stromschiene oder Leiterschleife vorgegebenen Hauptstrompfad so angepasst ist, dass ein in die Testleiterschleife eingeleiteter modulierter Teststrom im Messbereich des Stromsensors zusammen mit einem Strom im Hauptstrompfad magnetfeldsensitiv abtastbar ist.

Mit magnetfeldsensitiver Strommessung bzw. mit einem magnetfeldsensitiven Stromsensor soll im Zusammenhang mit der Erfindung eine Strommessung verstanden werden, die auf einer Änderung des elektrischen Widerstands eines Materials unter Änderung eines äußeren Magnetfeldes basieren. Dazu gehören insbesondere der anisotrope magnetoresistive Effekt (AMR-Effekt), der Riesenmagnetowiderstand (GMR-Effekt), der kolossale magnetoresistive Effekt (CMR-Effekt), der magnetische Tunnelwiderstand (TMS-Effekt) sowie der planare Hall-Effekt.

Vorteilhaft ist die Testleiterschleife mit einem Teststromgenerator zur Erzeugung eines modulierten oder gepulsten Teststroms verbunden. Dabei sind die Testleiterschleife und der Teststromgenerator vorzugsweise von der Leiterschleife oder Stromschiene des Hauptstrompfades vollständig galvanisch getrennt.

Zweckmäßig ist die Testleiterschleife als zu dem vorgegebenen Hauptstrompfad der Leiterschleife/Stromschiene parallele Testleiterbahn unter dem Stromsensor ausgebildet.

Die Testleiterschleife ist bevorzugt als zu der vorgegebenen Messebene parallele Testleiterschicht(en) der Leiterschleife mit zu dem vorgegebenen Hauptstrompfad der Leiterschleife parallelen Testleiterbahnen in Multilayer-Dünnschichttechnik auf einer Sensorleiterplatte des Stromsensors integriert. Sie kann aber auch vorteilhaft als zu dem vorgegebenen Hauptstrompfad paralleles Leitungsframe in einer oder mehreren Schichten auf einem Chip des magnetfeldsensitiven Sensorelements des Stromsensors realisiert sein.

In einer bevorzugten Ausführung ist die Testleiterschleife als eine Art Spiralform mit mehreren parallelen Leiterbahnabschnitten zu dem vorgegebenen Hauptstrompfad der vom Stromsensor abgetasteten Stromschiene/Leiterschleife ausgebildet. Dabei kann sie auch als Doppelspirale in verschiedenen Schichten einer Trägerleiterplatte des Stromsensors angebracht

Der Teststromgenerator ist vorteilhaft ein Impulsgenerator zur Erzeugung definierter Stromimpulse. Dabei ist es bevorzugt, dass der Teststromgenerator mindestens einen Schalttransistor zur Impulserzeugung, einen Impulslängenbegrenzer und einen Strombegrenzer aufweist. Ferner kann der Teststromgenerator als Impulslängenbegrenzer einen seriellen Kondensator und als Strombegrenzer einen Festwiderstand aufweisen.

Besonders bevorzugt ist der Schalttransistor durch wenigstens ein Element aus der Gruppe Unipolartransistor, Bipolartransistor, Thyristor oder ein optoelektronisches Schaltelement gebildet. Der Teststromgenerator umfasst vorteilhaft einen Impulsgenerator zur Erzeugung von einzelnen Impulsen aus Rechteck-, Sägezahn- oder Sinusimpuls oder von Impulssequenzen daraus als Wiederkehr gleicher oder unterschiedlicher Impulsformen. Des Weiteren kann der Teststromgenerator auch so ausgelegt sein, um eine frei definierte Impulssequenz zu erzeugen, die zur Auswertung vorzugsweise mit Mustererkennungsalgorithmen angelernt werden kann.

Die erfindungsgemäße Vorrichtung bezieht sich auf Stromsensoren auf Basis eines magnetfeldsensitiven Effekts, der bevorzugt als Gradientensensor ausgebildet ist, kann aber verallgemeinert für beliebige magnetische Sensoren angewendet werden, da die Art des verwendeten magnetfeldsensitiven Sensorelements für die Funktionalität der Erfindung nicht von Bedeutung ist. D.h. das Testprinzip der Erfindung kann sowohl unter Verwendung von AMR-, CMR-, EMR-, GMR-, TMR-Sensoren (zusammengefasst als xMR-Stromsensoren) als auch für Sensoren auf Basis des Hall-Effekts verwirklicht werden.

Die Aufgabe wird weiterhin gelöst mit einem Verfahren zum Erkennen einer fehlerhaften Arbeitsweise eines Stromsensors auf Basis eines magnetfeldsensitiven Effekts an einer zur Strommessung abgetasteten Leiterschleife oder Stromschiene, umfassend die folgenden Schritte:

a. Bereitstellen einer zu der vom Stromsensor magnetfeldsensitiv abgetasteten Stromschiene oder Leiterschleife benachbart angeordneten, zusätzlichen abtastbaren Testleiterschleife zum Aufprägen eines modulierten Teststroms,

b. Erfassen von ersten Messwerten mittels des Stromsensors zur sukzessiven Strommessung und -überwachung in einem vorgegebenen Messbereich der abgetasteten Stromschiene oder Leiterschleife,

c. Erzeugen eines modulierten Teststromes mittels eines Teststromgenerators,

d. zeitlich begrenztes Einleiten des modulierten Teststromes in die Testleiterschleife,

e. Erfassen von zweiten Messwerten durch Strommessung mittels des Stromsensors bei Überlagerung von Magnetfeldern des Teststromes in der Testleiterschleife und des Stroms in der vom Stromsensor magnetfeldsensitiv abgetasteten Stromschiene oder Leiterschleife,

f. Bestimmen eines Differenzstromes aus ersten und zweiten Messwerten und Auswerten des Differenzstromes zum Erkennen von Abweichungen des Differenzstromes vom Signalverlauf des eingeleiteten Teststromes.

Vorzugsweise wird der Teststrom des Verfahrens als Einzelimpuls bereitgestellt. Er kann aber auch als definierte Impulssequenz bereitgestellt werden.

Dabei ist es vorteilhaft, dass der Teststrom als Rechteck-, Sägezahn- oder Sinusimpuls oder in der Impulssequenz daraus als Wiederkehr gleicher oder unterschiedlicher Impulse bereitgestellt wird. Er kann aber auch als frei definierte Impulssequenz erzeugt und gegebenenfalls zur Auswertung mit Mustererkennungsalgorithmen angelernt werden.

Der Grundgedanke der Erfindung basiert auf der Idee, dass mittels einer unter einem herkömmlichen xMR-Stromsensor zusätzlich angebrachten Leiterstruktur, die als planar ausgebildete Leiterschleife von einem Teststromgenerator zeitweise mit einem modulierten Teststrom, z.B. Einzelimpuls oder definierte Impulssequenz, beaufschlagt wird, ein definiertes und zeitlich begrenztes Magnetfeld als ein zusätzlicher Offset zu dem durch den zu messenden Strom im Hauptstrompfad der Stromschiene hervorgerufenen Magnetfeld am xMR-Stromsensor überlagert und als Magnetfeldmodulation erfasst werden kann, indem von wenigstens zwei aufeinanderfolgend aufgenommenen Strommesswerten mit und ohne Teststrombeaufschlagung der Offsetanteil abgetrennt und mit dem vom Teststromgenerator ausgesendeten Teststromverlauf verglichen wird.

Die Einsatzgebiete des erfindungsgemäßen Testverfahrens für xMR Stromsensoren sind unbegrenzt und können, angefangen in Steuerungselektronik von Fahrzeugantrieben über Leistungselektronik in Flugzeugen, Schiffen und der Raumfahrt, bis zur Überwachung von Schnellladegeräten oder Frequenzumrichtern reichen. Dabei können mit Hilfe dieses Verfahrens hohe Sicherheitsanforderungen schnell und präzise erfüllt werden, die vom einfachen BIST (Built-in Self-Test) bis hin zu komplexen Testabläufen während des aktiven Gerätebetriebs reichen und sind damit potenziell für alle Einsatzgebiete zur Gewährleistung der funktionalen Sicherheit (z.B. SIL- und ASIL-Level, Ausfallsicherheit, Personenschutz usw.) geeignet.

Durch die erfindungsgemäße Vorrichtung und das zugrundeliegende Verfahren ist es möglich, die fehlerfreie Arbeitsweise von Stromsensoren mit magnetischer Abtastung zu prüfen, ohne dass der gemessene Stromfluss in der abzutastenden Leiterschleife beeinflusst oder verfälscht wird oder eine Unterbrechung zur Testung erforderlich ist, um Ausfallerscheinungen des magnetfeldsensitiven Stromsensors frühzeitig zu erkennen.

Die Erfindung soll nachfolgend durch Ausführungsbeispiele anhand von Zeichnungen näher beschrieben werden. Hierzu zeigen:

Fig. 1    einen erfindungsgemäß mit einer zusätzlichen Testleiterschleife versehenen Stromsensor zum Erkennen einer fehlerhaften Arbeitsweise, der über der Testleiterschleife auf einer Trägerleiterplatte oberhalb einer abzutastenden Stromschiene oder Leiterschleife eines Hauptstrompfades angeordnet ist,

Fig. 1A    einen gemäß Fig. 1 auf einer Trägerleiterplatte mit Testleiterschleife montierten Stromsensor, bei dem die Trägerleiterplatte auf einer vom Stromsensor abgewandten Oberfläche die abzutastende Leiterschleife des Hauptstrompfades gegenüberliegend zu Testleiterschleife und Stromsensor aufweist,

Fig. 2    drei beispielhafte Ausführungsformen der erfindungsgemäßen Testleiterschleife mit angepasster Testleitergeometrie je nach erforderlichem Magnetfeld passend zur Empfindlichkeit des Stromsensors sowie zur Geometrie und Größe des vom Hauptstrompfad typischerweise erzeugten Magnetfeldes,

Fig. 3    eine vorteilhafte Gestaltung eines Teststromgenerators zur Erzeugung eines modulierten Teststroms zur kurzzeitigen Beaufschlagung der Testleiterschleife durch einen mittels Schalttransistor erzeugten Testimpulses und Impulsstrom- und Impulslängenbegrenzung,

Fig. 3A    eine weitere vorteilhafte Ausführung eines Teststromgenerators zur Erzeugung eines modulierten Teststroms mit einem n-Kanal-MOSFET als bevorzugter Schalttransistor zur Impulserzeugung,

Fig. 3B    eine weitere beispielhafte Ausführung eines Teststromgenerators zur Erzeugung eines gepulsten Teststroms mit monostabiler Kippstufe mit NAND-Gliedern zur Impulsstrom- und Impulslängenbegrenzung,

Fig. 3C    eine weitere zweckmäßige Ausführung eines Teststromgenerators zur Erzeugung eines gepulsten Teststroms mit einer monostabilen Kippstufe mittels Timer- zur Impulsstrom- und Impulslängenbegrenzung IC,

Fig. 3D    eine weitere vorteilhafte Ausführung eines Teststromgenerators zur Erzeugung eines modulierten Teststroms mit einem durch Mikrocontroller gesteuerten n-Kanal-MOSFET zur gleichzeitigen Impulslängenbegrenzung,

Fig. 4    eine bevorzugte Ausführung des erfindungsgemäßen Stromsensors mit einer Beschaltung zur Ausfallüberwachung unter Ausnutzung von Komponenten üblicher Sensorbeschaltung,

Fig. 5    ein Ablaufschema des erfindungsgemäßen Verfahrens zum Erkennen der fehlerhaften Arbeitsweise eines Stromsensors ohne Beeinflussung des abzutastenden Hauptstrompfades,

Fig. 6    ein beispielhaft aufgenommener Stromverlauf mit möglichen Auswertungsmodi der Testimpulsüberlagerung bei unterschiedlichem Hauptstromverhalten,

Fig. 7    eine bevorzugte Sensorbeschaltung eines erfindungsgemäß überwachten Stromsensors unter Verwendung programmierbarer Hardware mit IP-Kern zur Implementierung des erfindungsgemäßen Verfahrens.

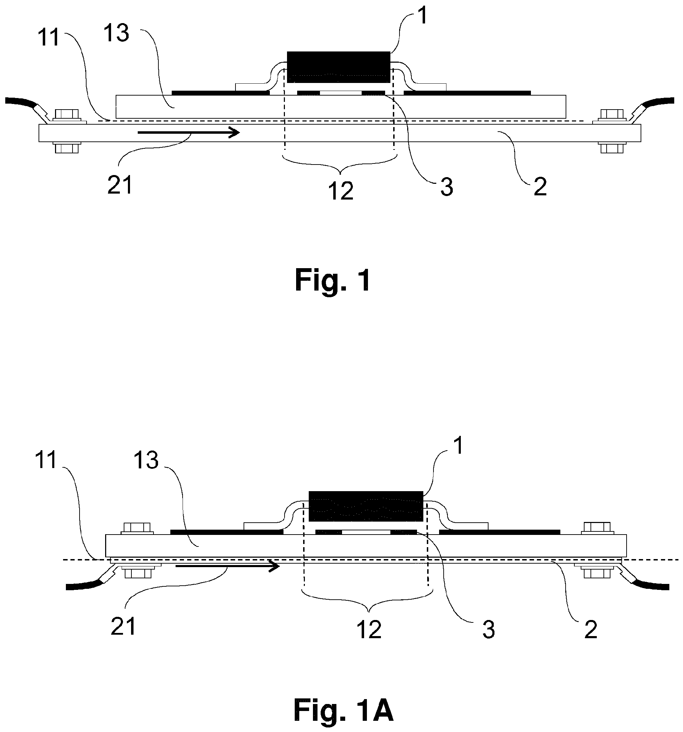

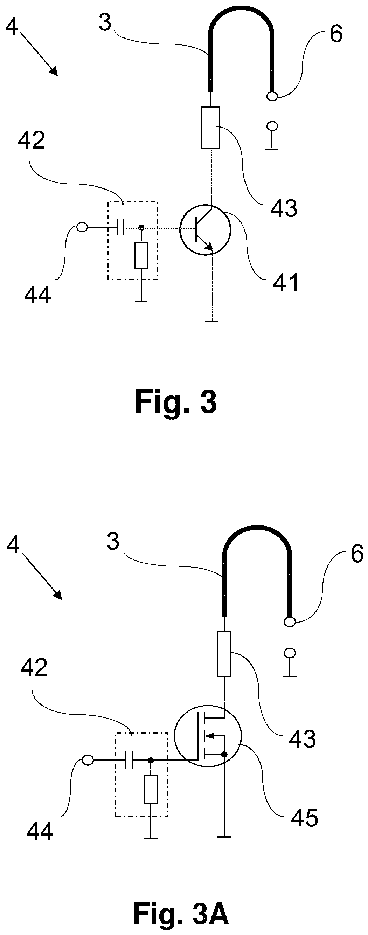

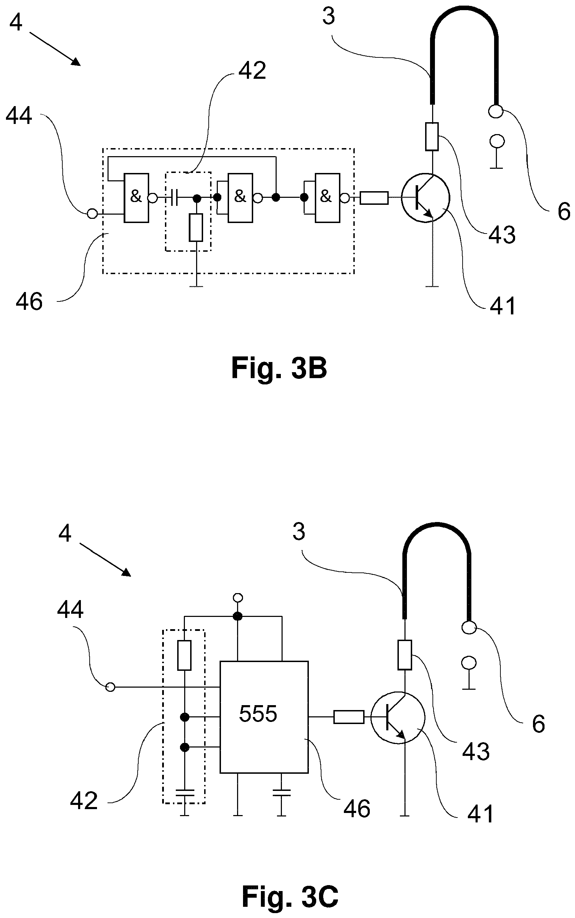

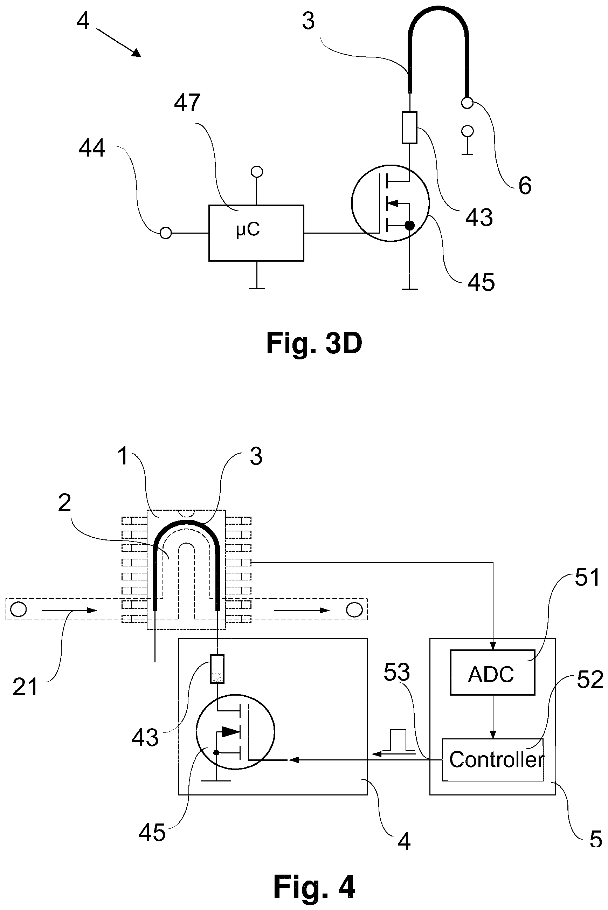

In einer Grundvariante besteht die Vorrichtung zum Erkennen einer fehlerhaften Arbeitsweise eines Stromsensors 1 auf Basis eines magnetfeldsensitiven Sensor, bevorzugt als Gradient-Sensor ausgebildet gemäß **Fig. 1** aus dem Stromsensor 1, eines abgetasteten Hauptstrompfades in Form einer Stromschiene oder Leiterschleife 2 (nachfolgend verkürzt nur Leiterschleife 2), einer Testleiterschleife 3 und einem Teststromgenerator 4 (nur in Fig. 3, 4, 7 dargestellt), der die Testleiterschleife 3 zeitweise, d.h. zeitlich kurz begrenzt, mit einem modulierten Teststrom versorgt.

In den nachfolgenden Ausführungsbeispielen wird für die Strommessung als Kurzbezeichnung ein xMR-Stromsensor 1 genannt, wobei diese Bezeichnung stellvertretend für alle magnetfeldsensitiven Stromsensoren 1, z.B. auf Basis des AMR-Effekts, des GMR-Effekts, des CMR-Effekts und des TMS-Effekts sowie für Sensoren unter Nutzung des planaren Hall-Effekts, verwendet wird. Die vorgenannten Sensoren sind also beliebig wählbar.

Gemäß Fig. 1 ist ein ausgewählter xMR-Stromsensor 1, vorzugsweise ein AMR-Sensor, auf eine einfache Trägerleiterplatte 13 montiert, die üblicherweise auch für die Beschaltung des als integrierter Schaltkreis (IC) gefertigten Stromsensors 1 verwendet wird. Dieser Aufbau kann, je nach dem zu erwartenden Stromfluss und/oder der geforderten galvanischen Isolation, entweder über einer massiven abzutastenden Leiterschleife 2 (U-Form oder $\Omega$-Form bei Gradienten-Sensoren bevorzugt) platziert werden oder der Hauptstrompfad 21 kann ebenfalls als Leiterzug auf der dem Stromsensor 1 gegenüberliegenden Oberfläche der Trägerleiterplatte 13 (Fig. 1A) aufgebracht oder in einer Innenlage der Trägerleiterplatte 13 (nicht gezeichnet) eingebracht sein, wobei durch das Trägermaterial zugleich eine galvanische Trennung vorhanden ist. Zwischen Trägerleiterplatte 13 und Stromsensor 1 (wenn verlötet auf der Trägerleiterplatte 13) ergibt sich eine Lücke, die zur Aufbringung der Testleiterschleife 3 auf der Trägerleiterplatte 13 genutzt werden kann. Dabei ist die Testleiterschleife 3 vorzugsweise als Testleiterschicht 31 in Dünnschichttechnik aufgebracht und nachträglich in geeigneten Testleiterbahnen 32 geätzt worden.

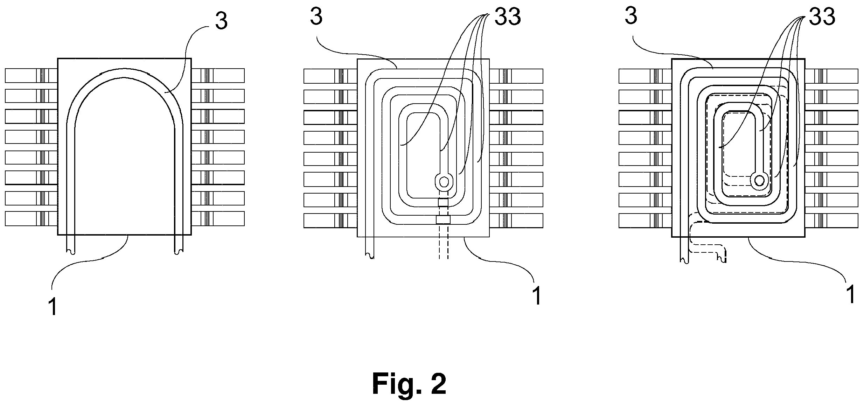

Die Form und Ausrichtung der Testleiterschleife 3 bzw. ihrer Testleiterbahn(en) 32 orientiert sich an dem Verlauf des Hauptstrompfades 21 der abzutastenden Leiterschleife 2. Dabei sind möglichst viele Teilbereiche der planar ausgebildeten Testleiterschleife 3 parallel zum Verlauf der Leiterschleife 2 auszurichten, wie es aus Fig. 2 in Form der parallelen Testleiterbahnabschnitte 33 zu erkennen ist. Grundsätzlich - auch wenn der Hauptstrompfad 21 nicht direkt gegenüberliegend an der Trägerleiterplatte 13 positioniert ist - wird durch die Lage der Trägerleiterplatte 13 und eine Messebene 11 des Stromsensors 1 definiert, zu der die Ebenen sowohl der abzutastende Leiterschleife 2 als auch der Testleiterschleife 3 parallel ausgerichtet sind. Durch die laterale räumliche Ausdehnung des (als IC-Baustein aufgesetzten) Stromsensors 1 ist zugleich der Messbereich 12 des Stromsensors 1 vorgegeben, in dem Leiterschleife 2 und Testleiterschleife 3 quasi übereinander zu positionieren sind, wobei die Testleiterschleife 3 vorzugsweisenäher am Stromsensor 1 liegt, um mit geringeren Testströmen ein ausreichendes Magnetfeld zur Überlagerung mit dem Feld des Hautstrompfades 21 zu erhalten.

In **Fig. 2** sind in drei Teilabbildungen ausgewählte Beispiele für die Gestaltung der Testleiterschleife 3 dargestellt, die an den (nur in Fig. 4 gestrichelt gezeichneten) U-förmigen Verlauf der abzutastenden Leiterschleife 2 sowie an den AMR-Sensortyp gut angepasst sind. Wichtigstes übereinstimmendes Merkmal aller drei Formen sind die zur Leiterschleife 2 parallel ausgerichteten Testleiterbahnabschnitte 33, die eine hinreichend gleichbleibende Überlagerungsstrecke der Magnetfelder der beiden Ströme (Testleiterstrom und Strom im Hauptstrompfad 21) innerhalb des Messbereichs 12 des Stromsensors 1 gewährleisten. Für das Testverfahren ist die schmale Testleiterschleife 3, deren Geometrie je nach notwendiger Empfindlichkeit des xMR-Stromsensors 1 verschiedenartig ausgeführt sein kann, direkt unter dem Stromsensor 1 auf der Trägerleiterplatte 13 angebracht. In den meisten Fällen, bei denen hohe Ströme von Leistungselektronik zu messen sind, genügt es, wie in der ersten Teilabbildung von Fig. 2 gezeichnet, die Testleiterschleife 3 mit lediglich einer Leiterbahn 31 auszuformen, die der U- oder $\Omega$-förmig im Hauptstrompfad 21 ausgebildeten Leiterschleife 2 angeglichen ist und im Idealfall zu dieser direkt parallel nachgebildet ist. Der Anteil der magnetischen Feldstärke, die von der Testleiterschleife 3 generiert wird, muss dabei allerdings immer einen so hohen zusätzlichen Betrag zu der vom Hauptstrompfad 21 erzeugten magnetischen Feldstärke besitzen, um den zusätzlichen Teststrom als ausreichend deutlichen Offset zum von der Leiterschleife 2 erzeugten Magnetfeld messen und ihn zuverlässig vom Messwert des Hauptstrompfades 21 abtrennen zu können.

Die Anzahl der schmalen Testleiterbahnen 32, die parallel zur Leiterschleife 2 des Hauptstrompfades 21 ausgerichtet sind, ist umso größer zu wählen, je geringer die Empfindlichkeit des Stromsensors 1 ist oder je schwächer das Magnetfeld der abzutastenden Leiterschleife 2 auf den Stromsensor 1 einwirkt. Die in der zweiten Teilabbildung von Fig. 2 dargestellte Variante der Testleiterschleife 3 trägt der letztgenannten Situation dadurch Rechnung, dass eine schematisch gezeichnete Spiralform der Testleiterbahn 32 mit einer Mehrzahl von parallelen Testleiterbahnabschnitten 33 parallel ausgerichtet zur Leiterschleife 2 (nur in Fig. 4 sichtbar) gewählt wurde, damit sich die auftretenden magnetischen Felder der einzelnen Testleiterbahnabschnitte 33 aufsummieren.

In der dritten Teilabbildung von Fig. 2 ist die Anzahl der Testleiterbahnabschnitte 33 noch weiter erhöht, indem eine gleichlaufende Doppelspiralform in mehreren Lagen der Trägerleiterplatte 13 aufgebracht ist. Damit wird das aus allen magnetischen Feldanteilen der einzelnen Testleiterbahnabschnitte 33 kumulierte Testleitermagnetfeld nochmals deutlich größer.

Die planare Anordnung der Testleiterschleife 3 ist nicht auf eine Leiterstruktur auf der Trägerleiterplatte 13 außerhalb des xMR-Stromsensors 1 begrenzt, sondern sie kann - wenn es die technischen und konstruktiven Möglichkeiten zulassen - auch direkt in den xMR-Stromsensor 1 integriert sein. Die Testleiterschleife 3 muss in jedem Fall so geformt und (in Lage und Ausrichtung) so positioniert sein, dass sie einen erforderlichen Testimpulsstrom mit ausreichend hoher Feldstärke parallel zum Hauptstrompfad 21 für den xMR-Stromsensor 1 bereitstellt. Die Schichtdicke und die Leiterbahnbreite der Testleiterschleife 3 kann innerhalb der Herstellungsmöglichkeiten nahezu frei gewählt und mathematisch definiert vorgegeben werden. Das entstehende magnetische Feld muss einen ausreichend großen Abstand zur bekannten Messtoleranz des xMR-Stromsensors 1 besitzen werden. Die Stromstärke bzw. Sprunghöhe der Testimpulse müssen so bemessen sein, dass der xMR-Stromsensor 1 nicht in die Sättigung mit dem maximal erwarteten zu messenden Hauptstrom gesteuert wird. Aus energetischer Sicht sollte der Teststrom so niedrig wie möglich gewählt werden.

In **Fig. 3** ist eine beispielhafte Ausführung für ein mögliches Grundprinzip des Teststromgenerators 4 der erfindungsgemäßen Vorrichtung abgebildet. Im Bereich der ausschließlich dargestellten Testleiterschleife 3 ist in Fig. 3 auf die Einzeichnung des Stromsensors 1 und der Leiterschleife 2, die sich bezüglich der Zeichnungsebene darüber bzw. darunter befinden würden, aus Übersichtlichkeitsgründen verzichtet worden. Der Teststromgenerator 4 wird in diesem Beispiel als Impulsgenerator 41 durch einen Schalttransistor gebildet, der annähernd einen Rechteckimpuls ausgibt. Dies kann durch Unipolartransistor, Bipolartransistor (NPN/PNP), Thyristor oder optoelektronische Schaltelemente oder idealerweise durch einen MOSFET erfolgen. Die eigentliche Testimpulslänge wird dabei durch einen Impulslängenbegrenzer 42 in Form eines Serien-Kondensators und einen Strombegrenzer 43 in Form eines Festwiderstands definiert, kann aber auch durch andere elektronische Schaltungslösungen begrenzt oder durch Steuerlogik definiert werden, wie nachfolgend mit Bezug auf Fig. 3B-3C angegeben. Dadurch kann auch bei einer fehlerhaften Funktion am Eingang 44 vom Teststromgenerator 4 kein Dauerstrom in der Testleiterschleife 3 entstehen. Somit schützen der Impulslängenbegrenzer 42 und der Strombegrenzer 43 vor einer möglichen Überlastung des Schalttransistors. Wenn der Schalttransistor als Impulsgenerator 41 am Eingang 44 des Teststromgenerators 4 entsprechend angesteuert und von einer Hauptstromversorgung 6 gespeist wird, gibt der Teststromgenerator 4 vorzugsweise einen Rechteckimpuls in die Testleiterschleife 3 ab.

Durch einen definierten Strombegrenzer 43, beispielsweise mittels Festwiderstand (wie in Fig. 3, 4 u. 7 gezeigt), wird der maximal fließende Teststrom eingestellt. Ein gepulster Betrieb über eine schaltbare Konstantstromquelle anstelle des Impulsgenerators 41 ist ebenfalls möglich. Der Teststromgenerator 4 kann bevorzugt eine eigene, vom Messsystem (Stromsensor 1 am Hauptstrompfad 21) unabhängige Stromversorgung 6 besitzen (galvanische Trennung), kann aber auch mit dem Hauptstrompfad 21 gekoppelt sein, wenn dieser beispielsweise direkt an der Stromversorgung 6 angeschlossen ist. Letzteres hat aber den Nachteil der Aufhebung der galvanischen Trennung. Vorteil einer unabhängigen Stromversorgung 6 ist, dass die Testimpulsströme zu jedem beliebigen Zeitpunkt erzeugt werden können, unabhängig vom aktuellen Stromfluss des eigentlichen Hauptstrompfades 21.

In einer Ausführung des Teststromgenerators 4 gemäß **Fig. 3A** ist der Testimpulsgenerator 41 idealerweise durch einen MOSFET gebildet, um die Verlustleistung möglichst gering zu halten und keine zusätzlichen Verluste in den Testleiterschleife 3 mit einzubringen. Um die Dauer des fließenden Testimpulsstroms zu begrenzen und um im Fehlerfall mögliche Dauertestströme zu vermeiden, wird zusätzlich ein zeitbegrenzendes Glied integriert. In Fig. 3 ist dieser Impulslängenbegrenzer 42 durch eine einfache R-C Schaltung, die nur einen kurzen Impuls zu Ansteuerung des MOSFET 45 durchlässt, realisiert. Der Teststromgenerator 4 muss generell in der Lage sein, einen definierten Stromimpuls in bestimmter Höhe, die durch die Empfindlichkeit des xMR-Stromsensors 1 definiert ist und eine ausreichend hohe Aussteuerung im Stromsensor 1 hervorruft, sowie mit definierter Zeitdauer, die durch die minimale Reaktionszeit des xMR-Stromsensors 1 zur Strommessung bestimmt ist, zu liefern. Durch eine festgelegte Strombegrenzung, beispielsweise mittels Festwiderstand als Strombegrenzer 43, wird der maximal mögliche fließende Testimpulsstrom begrenzt. Das Schaltprinzip ist sehr einfach. Zunächst wird der aktuell fließende Strom durch die mit dem xMR-Stromsensor 1 abzutastende Leiterschleife 2 als Stromesswert erfasst. Danach erfolgt die Auslösung des Teststromgenerators 4. Legt man ein positives Schaltsignal an den auslösenden Eingang 44 des Teststromgenerators 4 an, dann beginnt durch den Kondensator des Impulslängenbegrenzers 42 ein Strom zu fließen, der durch den zugehörigen Widerstand des RC-Gliedes begrenzt wird, sodass der Kondensator nicht zu schnell geladen werden kann. Durch die Impedanz des Kondensators wird zunächst der MOSFET 45 durchgesteuert und über der Testleiterschleife 3 stellt sich ein durch den Strombegrenzer 43 festgelegter Stromfluss ein. Erst danach kann die Strommessung mit dem zusätzlichen Teststromoffset durch den xMR-Stromsensor 1 erfolgen. Erreicht die Aufladung des Kondensators des Impulslängenbegrenzers 42 die Abschaltschwelle des MOSFET 45, sperrt der MOSFET 45 den Teststrom über der Leiterschleife 3 wieder. Wird nun der Eingang 44I des Teststromgenerators 4 wieder auf 0V gelegt, so wird der Kondensator des Impulslängenbegrenzers 42 automatisch wieder entladen und der Teststromgenerator 4 steht wieder für einen erneuten Teststromimpuls zur Verfügung. Die Länge des Testimpulses ergibt sich dabei aus der Kapazität des Kondensators, dem Nominalwert des Widerstands und den Schaltschwellen des MOSFET 45.

In **Fig. 3B** und **Fig. 3C** sind weitere mögliche Varianten des Impulsgenerators 41 für die Realisierung des Teststromgenerators 4 dargestellt, diese nach dem Prinzip der monostabilen Kippstufe arbeiten.

Wie in **Fig. 3B** dargestellt, kann die Ansteuerung der monostabilen Kippstufe mittels Standard-Logik-NAND-Gattern und einem RC-Glied erfolgen. Diese Schaltung hat den Vorteil gegenüber Fig. 3A, dass die RC-Lade-/Entladeschaltung sowohl vom Eingang 44 als auch vom Schalttransistor des Impulsgenerators 41 entkoppelt ist und damit eine konstantere Zeitbegrenzung ermöglicht.

In **Fig. 3C** ist eine weitere Schaltungsvariante mit einem typischen Timer-IC 46 (z.B. NE555, CA555, TLC555 usw.) als zeitbegrenzendes Element ausgeführt. In diesem Beispiel wird als Impulsgenerator 41 ein bipolarer NPN-Transistor verwendet, der aber ebenfalls als MOSFET 45 ausgeführt sein kann.

**Fig. 3D** zeigt eine Beispielvariante für den Teststromgenerator 4 mit einem Mikrocontroller 47. Die Zeitbegrenzung wird hier digital im Programmcode des Mikrocontrollers 47 gesteuert und benötigt keine externen Widerstände und Kondensatoren zur Zeitbeeinflussung. Damit können bestimmte parasitären Einflüsse, z.B. Temperatur, die auf die passiven Bauteile (RC-Glieder) der vorherigen Beispiele wirken, eliminiert und eine Synchronisation mit den Testmessungen zur Erfassung der Testimpulse vereinfacht werden.

Durch die vorstehend beschriebene Verwendung von monostabilen Kippstufen kann selbst bei einer fehlerhaften Funktion am Steuersignal des Teststromgenerators 4 kein Dauerstrom in der Testimpulsschleife 3 entstehen, der das Testergebnis und die Strommessung des Hauptstrompfades 21 verfälschen würde. Zusätzlich werden der Strombegrenzer 43 und Impulsgenerator 41 in Form eines einfachen Schaltelements vor einer möglichen Überlastung durch Dauerstrom in einem Defektfall geschützt. In diesem Schaltungsbereich auftretende Defekte können durch das erfindungsgemäße Testverfahren ebenfalls sicher detektiert werden. Ändert sich beispielsweise der Differenzstromwert $I_D$ nach dem Auslösen des Teststromimpulses nicht und der Strommesswert aus dem Hauptstrompfad 21 liegt innerhalb eines Erwartungswertfensters, dann kann auf einen Defekt des Impulsgenerators 41 geschlossen werden.

Für eine BIST-Funktionalität (Build-In Self-Test) kann dieser Test beispielsweise auch bei einem stromlosen Hauptstrompfad 21 erfolgen, d.h. beispielsweise kann zunächst nach dem Einschalten des zu überwachenden Gerätes die Funktionalität des Teststromgenerators 4 selbst geprüft werden, bevor der eigentliche Hauptstrompfad 21 aktiviert wird. Der Teststromgenerator 4 kann sowohl eine eigene, vom Messsystem (Stromsensor 1) unabhängige Stromversorgung 6 besitzen (z.B. für eine galvanische Trennung), kann aber auch mit der Leiterschleife 2 gekoppelt sein, wenn dieser beispielsweise direkt an einer Hauptstromversorgung angeschlossen ist. Dies hat aber den Nachteil in der Aufhebung der galvanischen Trennung. Vorteil einer unabhängigen Stromversorgung ist, dass zu jedem beliebigen Zeitpunkt die Testimpulsströme erzeugt werden können, unabhängig vom aktuellen Zustand und Stromfluss des eigentlichen Hauptstrompfads. Wird für die Stromversorgung 6 des Testimpulsgenerators 4 ein einfacher Energiespeicher (z.B. Kondensator, der zyklisch geladen wird) verwendet, kann auch ein einfacher vorhandener GPIO-Pin 53 eines integrierten Schaltkreises 52 oder eine andere vorhandene Stromversorgung (z.B. auch durch Energierückgewinnung - Energy Harvesting - gewonnene Energie aus der Leiterschleife 2 selbst) verwendet werden.

Bei einer schnellen Reaktionszeit der xMR-Stromsensoren 1 auf Stromänderungen kann die Impulsstromdauer sehr kurz gewählt werden (z.B. < 50 μs bei AMR-Stromsensoren). Damit werden auch energetische Gesichtspunkte berücksichtigt und es können auch im Fehlerfall sehr kurze Reaktionszeiten erreicht werden, was z.B. bei sicherheitsrelevanten Systemen von großer Bedeutung ist. In der Sensorbeschaltung 5 auftretende Defekte können durch das Testverfahren sicher detektiert werden. Der bereitgestellte Teststrom kann verschiedenartig generiert werden. Er muss in der Lage sein, einen definierten Stromimpuls in bestimmter Höhe und begrenzter Zeit, z.B. 80 bis 200 mA, vorzugsweise 100 mA bei einem typischen AMR-Stromsensor, für wenigstens 50 μs zu liefern.

In **Fig. 4** ist ein typischer Gesamtaufbau der Vorrichtung zum Erkennen einer fehlerhaften Arbeitsweise eines Stromsensors 1 dargestellt. Das Testverfahren lässt sich in bestehende Strommesssysteme einfach, ohne hierfür zusätzliche Leitungen oder Modifikationen an der bestehenden Systemauslegung erforderlich zu machen, integrieren. Das ist deshalb möglich, da zur Messung des erzeugten Teststromoffsets die schon für die normale Strommessung vorhandene Auswerteelektronik (in Fig. 4: Analog-Digital-Wandler - ADC 51 - und Mikroprozessor/ Mikrocontroller 52) mitverwendet wird. Dadurch ist außer dem Teststromgenerator 4 keinerlei zusätzliche Hardware erforderlich. Lediglich ein einfacher schaltbarer Ausgangs-Pin 53 (z.B. GPIO-Pin - General Purpose Input/Output Pin) zur definierten Ansteuerung des Impulsgenerators 41 ist nötig. Dabei muss die Testimpulslänge lediglich an die notwendige Maximalimpulsdauer, basierend auf der maximalen Reaktionszeit des xMR-Stromsensors 1, sowie an die Abtastgeschwindigkeit (engl. sample rate) angepasst sein. Längere Zeiten werden durch die Verwendung eines impulsbegrenzenden Bauteils (z.B. Kondensator des Impulslängenbegrenzers 43) oder zeitbestimmende Bauteile (z.B. monostabile Kippstufen, Timer-IC oder Mikrocontroller) begrenzt. Der Teststromgenerator 4 ist in Fig. 4 lediglich schematisch dargestellt, entspricht aber mindestens den in Fig. 3 und Fig. 3A-3D offenbarten Varianten des Teststromgenerators 4.

Weiterhin ist es möglich, dass der Teststromgenerator 4 selbstständig periodische Teststromimpulse (z.B. mit Hilfe einer astabilen Kippstufe 46) generiert und die jeweils aktive Phase über ein Signal zur Auswerteelektronik signalisiert. Damit kann die Auswerteelektronik zwischen einem aktiven oder inaktiven Zustand des Teststromgenerators unterscheiden und den gemessenen Stromwert mit oder ohne zusätzlichen Testimpulsstromoffset zuordnen. Aufbauend auf diesem Testprinzip lässt sich der Teststromgenerator und damit das Testprinzip auch direkt mit der Schaltfrequenz von zu überwachenden Umrichtern synchronisieren, sodass die Messungen immer innerhalb der aktiven oder auch inaktiven Schaltzyklen des Umrichters erfolgen können. Durch die kurzen Wandlungszeiten des xMR-Stromsensors 1 sind auch mehrere aufeinanderfolgende Messungen des Differenzstromwertes $I_D$ problemlos möglich.

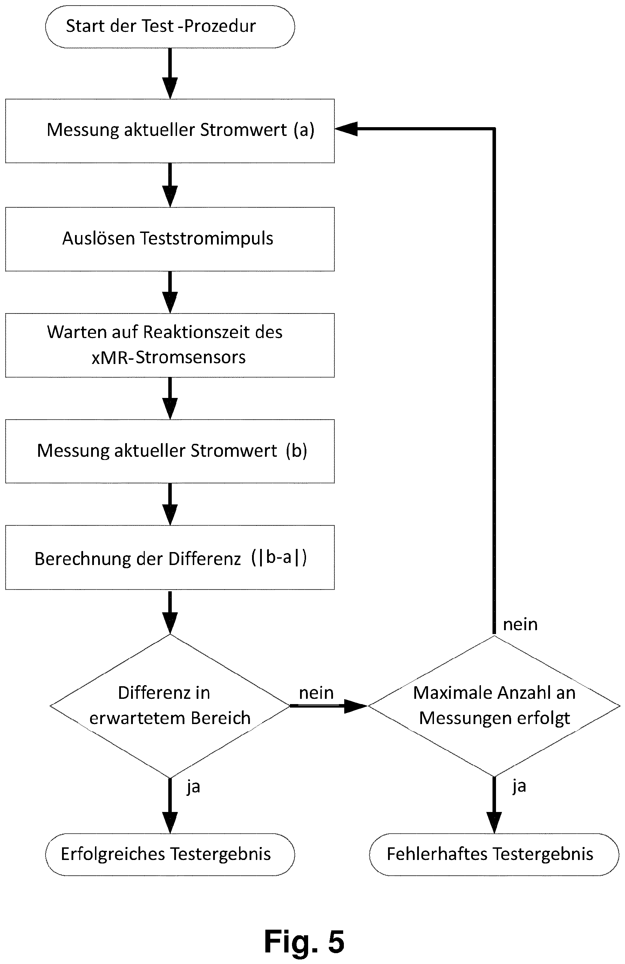

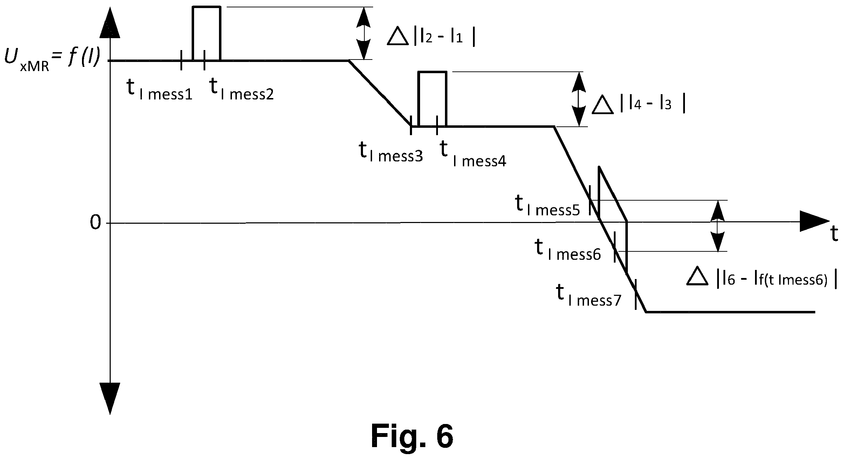

Das erfindungsgemäße Verfahren zum Erkennen einer fehlerhaften Arbeitsweise eines Stromsensors 1 ist in **Fig. 5** dargestellt. Das darin enthaltene Plausibilitäts-Messprinzip beruht auf einer einfachen zyklischen Differenzstrommessung. In Fig. 5 ist das Verfahren als Ablaufdiagramm gezeichnet, mit dem das erfindungsgemäße Testprinzip durchgeführt werden kann. Zunächst wird der aktuell auf dem Hauptstrompfad 21 fließende Strom mit Hilfe des xMR-Stromsensors 1 und einem nachgeschalteten Analog-Digital-Wandler ADC 51 bestimmt. Dann erfolgt das Auslösen eines Teststromgenerators 4, wodurch ein Testimpuls oder eine kurze Impulssequenz der Testleiterschleife 3 zugeführt und, nach einer kurzen Wartezeit, eine erneute Messung des aktuellen Stromwerts vorgenommen wird, der sich nun aus der Summe des Stromwerts des Hauptstrompfades 21 und dem zusätzlich beaufschlagten Teststrom zusammensetzt (genau genommen: Summe der stromproportionalen Magnetfelder). Die Wartezeit ist notwendig, sodass sich der modulierte Teststrom und damit das magnetische Feld in voller Höhe einstellen kann und die Reaktionszeit des xMR-Stromsensors 1 für den korrekten Strommesswert erreicht ist. Zu diesem Zeitpunkt ergibt sich der resultierende Messstromwert des xMR-Stromsensors 1 aus dem Stromfluss des Hauptstrompfads 21 und des zusätzlichen definierten Teststroms, der durch einen Widerstand des Strombegrenzers 43 begrenzt wird. Aus den zeitlich eng benachbarten Messwerten, vor und während des aktiv fließenden Teststroms, wird nun der Differenzstrombetrag $I_D$ bestimmt. Eine zusätzliche Messsicherheit kann durch eine darauffolgende dritte Messung erreicht werden, die wieder ohne aktiven Testimpulsstrom ausgeführt wird (siehe auch Fig. 6).

Um eventuell auftretende plötzliche Stromänderungen auf dem Hauptstrompfad 21 zwischen den Differenzstrommessungen $I_D$ nicht als Pseudo-Fehler zu erkennen, kann das Testverfahren mehrfach sequentiell angewendet werden, bis eine für die Anwendung vorgegebene maximal erlaubte Iterationszahl erreicht wird. Die betragsmäßige Berechnung der Stromdifferenzbeträge $I_D$ aus den beiden Strommesswerten, ohne Teststrom und mit Teststrom, ergibt dann den gemessenen Teststromwert. Dieser Wert muss sich in einem erwarteten Toleranzbereich bewegen. Ist der ermittelte Teststrom außerhalb dieses Toleranzbereiches und die maximal für die Anwendung vorgegebene Iterationszahl ist noch nicht erreicht, dann erfolgt eine erneute Differenzstrommessung, zunächst ohne Teststrom und danach wieder mit Teststrom. Ist die maximal für die Anwendung vorgegebene Iterationszahl erreicht, dann liegt ein Fehler des xMR-Stromsensors oder der Stromsensorbeschaltung vor und es können erforderliche Sicherheitsmaßnahmen ergriffen werden. Liegt der ermittelte Differenzstromwert $I_D$ im Toleranzbereich und die maximal vorgegebene Iterationszahl ist noch nicht erreicht, so ist das Testergebnis erfolgreich und plausibel.

In **Fig. 6** ist die Verfahrensweise dazu schematisch in einem Graphen dargestellt. Zunächst ist eine normale Differenzstrommessung mit zwei Messpunkten, einmal vor dem Auslösen des Teststromgenerators 4 mit dem Messwert $t_{I\,mess1}$ und nach dem Auslösen des Teststromgenerators 4 mit dem Messwert $t_{I\,mess2}$ dargestellt. Am Zeitpunkt $t_{I\,mess2}$ ist der sich ergebende Offset $\Delta|\,I_2\text{-}I_1\,|$ des Testimpulsstroms auf dem Hauptstrom bei der Strommessung schematisch dargestellt. Eine weitere Absicherung der Plausibilität der Messwerte, z.B. bei sich während der Strommessung ändernden Hauptstromwertes, kann durch eine erneute Strommessung nach Beendigung des Testimpulses und der nachfolgenden Linearisierung aller 3 Strommesswerte zur Bestimmung des eigentlichen Stromoffsetwertes durch den Testimpulsstrom erfolgen. Dazu wird zunächst aus den Strommessungen $t_{I\,mess3}$ vor der Auslösung des Teststrom-Impulsgenerators 41 und nach der Beendigung des Teststromimpulses $t_{I\,mess5}$ die linear angenäherte Funktionsgleichung für die Stromänderung des Hauptstrompfades an dieser Stelle berechnet (Gl. 1).

Dadurch lässt sich angenähert bzw. linearisiert der Stromwert des Hauptstrompfades 21 an der Stelle $t_{I\,mess4}$ bestimmen, welcher für die betragsmäßige Stromdifferenz zum Testimpulsstrom für das erfindungsgemäße Testverfahren benötigt wird

$$I(t) = \frac{I_{mess7} - I_{mess5}}{t_{Imess7} - t_{Imess5}} \cdot (t_{Imess6} - t_{Imess5}) + I_{mess5} \qquad \text{(Gl. 1)}$$

Danach kann der Differenzstrombetrag $I_D$ an der Stelle $t_{Imess6}$, welcher für die Berechnung vereinfacht in der Mitte zwischen den Zeitpunkten der Strommessung $t_{I\,mess5}$ und $t_{I\,mess7}$ liegt, nach Gl. 2 berechnet werden.

$$\Delta I_{tImess6} = I_{mess6} - \frac{I_{mess7} - I_{mess5}}{t_{Imess7} - t_{Imess5}} \cdot \left( \frac{t_{Imess7} - t_{Imess5}}{2} \right) + I_{mess5} \qquad \text{(Gl. 2)}$$

Befindet sich der Differenzstrombetrag $I_D$ außerhalb eines festgelegten Wertebereichs (Fenster), so liegt ein Problem am xMR-Stromsensor 1 oder am Teststromgenerator 4 vor und geeignete Sicherheitsmaßnahmen können eingeleitet werden.

Das Testverfahren lässt sich bei einer vom Hauptstrompfad 21 getrennten Stromversorgung 6 des Teststromgenerators 4 ebenfalls bei negativen Strömen auf dem Hauptstrompfad 21, z.B. während Rekuperationsphasen (Energierückgewinnung), durchführen. Damit ist das Testverfahren völlig unabhängig von der Hauptstromflussrichtung, da nur die Differenzbeträge der gemessenen Ströme zu den jeweiligen Messzeitpunkten (gemäß Fig. 5) erfasst werden. Das erfindungsgemäße Testverfahren kann sowohl bei DC-, als auch bei AC- oder gepulsten Hauptströmen angewandt werden.

Gerade im industriellen Fertigungsprozess oder im Automotive Bereich sind solche Testverfahren im laufenden Betrieb essentieller Bestandteil der notwendigen Sicherheitsanforderungen. Der große Vorteil dieser Erfindung besteht in der Möglichkeit dieses Testverfahren jederzeit im laufenden Betrieb (in situ) anzuwenden und somit eine Ausfallfrüherkennung sicherzustellen.

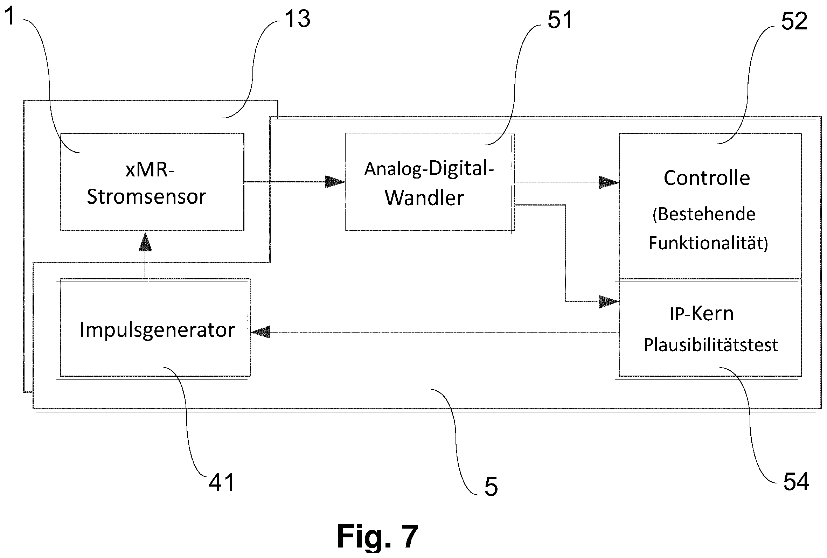

Eine weitere Ausführung der Vorrichtung zum Erkennen einer fehlerhaften Arbeitsweise des Stromsensors 1 zeigt **Fig. 7.** Durch die Verwendung eines vorgefertigten IP-Kerns 54 (Intellectual Property Core) in programmierbaren Bausteinen (z.B. FPGA, Mikrocontroller) für dieses Testverfahren als implementierte Software/Firmware oder Hardwareprogrammierungen kann die Integration dieses Testverfahrens sehr einfach in oder an bestehenden Controllern 52 einer Sensorbeschaltung 5 vorgenommen werden. Dabei spielt es keine Rolle, welche Art von Controller 52 (z.B. Mikroprozessor, digitaler Signalprozessor (DSP), Mikrocontroller oder FPGA) eingesetzt wird. Das ermöglicht eine universelle und einfache Implementierung und Nutzung des Testverfahrens in Neuentwicklungen oder als Erweiterung bestehender Messsysteme mit xMR-Stromsensor 1. Dabei können die für das Verfahren notwendigen Einheiten beliebig in einer Sensorbeschaltung 5 (z.B. Platine) platziert werden, d.h. der Teststromgenerator 4 kann sowohl eine eigenständige Einheit sein, sich entweder auf der Trägerleiterplatte 13 des xMR-Stromsensors 1 oder auf einer Platine der Sensorbeschaltung 5 befinden.

Eine weitere Ausführung besteht darin, dass ein Sensor-Chip in Dünnschichttechnik auf Siliziumwafer in einer Art Multilayer-Technik prozessiert wird. Das umfasst strukturierte Innenlagen und verschiedene Formen von Durchkontaktierungen für die Leiterschleife.

Somit sind die Realisierungs- und Einsatzmöglichkeiten dieses erfindungsgemäßen Testverfahrens für magnetfeldsensitive Stromsensoren 1 praktisch unbegrenzt, angefangen in Fahrzeugantrieben, Leistungselektronik in Flugzeugen, Schiffen und der Raumfahrt, bis hin zur Überwachung von Schnellladegeräten oder Frequenzumrichtern. Insbesondere können mit Hilfe dieses Verfahrens hohe Sicherheitsanforderungen schnell und präzise erfüllt werden: vom einfachen eingebauten Geräteselbsttest (BIST) bis hin zu komplexen Testabläufen bei laufendem Gerätebetrieb, um die funktionale Sicherheit (z.B. SIL- und ASIL-Level, Ausfallsicherheit usw.) zu gewährleisten. Dafür sind in vorhergehend offenbarten Gestaltungsformen nur einfache kostengünstige Ausführungsbeispiele zur Nachrüstung bekannter xMR-Stromsensoren 1 beschrieben, deren Implementierung in IC-Stromsensoren jedoch ebenfalls zum Gegenstand dieser Erfindung zu zählen sind.

Bezugszeichenliste

1 Stromsensor (magnetfeldsensitiver Stromsensor)
11 Messebene
12 Messbereich
13 Trägerleiterplatte

2 (abzutastende) Leiterschleife (bzw. Stromschiene)
21 Hauptstrompfad

3 Testleiterschleife
31 Testleiterschicht
32 Testleiterbahn
33 Testleiterbahnabschnitt

| 4 | Teststromgenerator |
|---|---|
| 41 | Impulsgenerator (Schalttransistor) |
| 42 | Impulslängenbegrenzer (Kondensator in RC-Glied) |
| 43 | Strombegrenzer (Festwiderstand |
| 44 | Eingang des Teststromgenerators |
| 45 | MOSFET |
| 46 | (monostabile) Kippstufe |
| 47 | Mikrocontroller (zur Steuerung der Impulslänge) |
| | |
| 5 | Sensorbeschaltung |
| 51 | ADC (Analog-Digital-Wandler) |
| 52 | Controller (Mikroprozessor, Mikrocontroller) |
| 53 | (schaltbarer) Ausgangspin (GPOI-Pin) |
| 54 | IP-Kern (zur Implementierung des Testverfahrens) |
| | |
| 6 | Stromversorgung |
| | |
| $I_T$ | Teststrom |
| $I_D$ | Stromdifferenz(-betrag) |

**Patentansprüche**

1. Vorrichtung zum Erkennen einer fehlerhaften Arbeitsweise eines Stromsensors (1) auf Basis eines magnetfeldsensitiven Sensorelements, das bevorzugt als Gradientensensor ausgebildet ist, umfassend

   - eine in einer Messebene (11) des Stromsensors (1) ausgebildete abgetastete Stromschiene oder Leiterschleife (2), die mindestens in einem Messbereich (12) durch den Stromsensor (1) abtastbar ist,
   **dadurch gekennzeichnet, dass**
   - in räumlicher Nachbarschaft zu der vom Stromsensor (1) abgetasteten Stromschiene oder Leiterschleife (2) eine Testleiterschleife (3) angeordnet ist, wobei
   - die Testleiterschleife (3) in einer zur Messebene (11) der abgetasteten Stromschiene oder Leiterschleife (2) parallelen Ebene angeordnet und an einen von der Stromschiene oder Leiterschleife (2) vorgegebenen Hauptstrompfad (21) so angepasst ist, dass ein in die Testleiterschleife (3) eingeleiteter modulierter Teststrom ($I_T$) zusammen mit einem Strom des Hauptstrompfads (21) im Messbereich (12) des Stromsensors (1) durch magnetfeldsensitive Abtastung erfassbar ist.

2. Vorrichtung nach Anspruch 1, **dadurch gekennzeichnet, dass** die Testleiterschleife (3) mit einem Teststromgenerator (4) zur Erzeugung des modulierten oder gepulsten Teststroms ($I_T$) verbunden ist.

3. Vorrichtung nach Anspruch 1, **dadurch gekennzeichnet, dass** die Testleiterschleife (3) und der Teststromgenerator (4) von der abgetasteten Leiterschleife (2) galvanisch getrennt sind.

4. Vorrichtung nach einem der vorherigen Ansprüche, **dadurch gekennzeichnet, dass** die Testleiterschleife (3) als zu dem vorgegebenen Hauptstrompfad (21) der Leiterschleife (2) parallele Testleiterbahn (31) unter dem Stromsensor (1) ausgebildet ist.

5. Vorrichtung nach einem der vorherigen Ansprüche, **dadurch gekennzeichnet, dass** die Testleiterschleife (3) als zu der vorgegebenen Messebene (11) der Leiterschleife (2) parallele Testleiterschicht (32) mit zu dem vorgegebenen Hauptstrompfad (21) der Leiterschleife (2) parallelen Testleiterbahnen (31) integriert ist in Multilayer-Dünnschichttechnik auf einer Sensorleiterplatte (13) des Stromsensors (1).

6. Vorrichtung nach einem der vorherigen Ansprüche, **dadurch gekennzeichnet, dass** die Testleiterschleife (3) als zu der vorgegebenen Messebene (11) der Leiterschleife (2) parallele Testleiterschicht (32) mit zu dem vorgegebenen Hauptstrompfad (21) der Leiterschleife (2) parallelen Testleiterbahnen (31) realisiert ist als Leitungsframe in einer oder mehreren Schichten auf einem Chip des magnetfeldsensitiven Sensorelements des Stromsensors (1).

7. Vorrichtung nach einem der vorherigen Ansprüche, **dadurch gekennzeichnet, dass** die Testleiterschleife (3) als eine Art Spiralform mit mehreren parallelen Leiterbahnabschnitten (33) zu dem vorgegebenen Hauptstrompfad (21) der vom Stromsensor (1) abgetasteten Leiterschleife (2) ausgebildet ist.

8. Vorrichtung nach einem der vorherigen Ansprüche, **dadurch gekennzeichnet, dass** der Teststromgenerator (4) ein Impulsgenerator (41) zur Erzeugung definierter Stromimpulse ist.

9. Vorrichtung nach Anspruch 8, **dadurch gekennzeichnet, dass** der Teststromgenerator (4) mindestens einen Schalttransistor (41) zur Impulserzeugung, einen Impulslängenbegrenzer (42) und einen Strombegrenzer (43) aufweist, wobei der Schalttransistor (41) durch wenigstens ein Element aus der Gruppe Unipolartransistor, Bipolartransistor, Thyristor oder ein optoelektronisches Schaltelement gebildet ist.

10. Vorrichtung nach Anspruch 8 oder 9, **dadurch gekennzeichnet, dass** der Teststromgenerator (4) als Impulslängenbegrenzer (42) einen seriellen Kondensator und als Strombegrenzer (43) einen Festwiderstand aufweist.

11. Vorrichtung nach einem der Ansprüche 8 bis 11, **dadurch gekennzeichnet, dass** der Teststromgenerator (4) einen Impulsgenerator (41) zur Erzeugung von einzelnen Impulsen aus Rechteck-, Sägezahn- oder Sinusimpuls oder von Impulssequenzen daraus als Wiederkehr gleicher oder unterschiedlicher Impulsformen aufweist oder so ausgebildet ist, um eine frei definierte Impulssequenz zu erzeugen, die zur Auswertung, vorzugsweise mit Mustererkennungsalgorithmen, angelernt werden kann.

12. Verfahren zum Erkennen einer fehlerhaften Arbeitsweise eines Stromsensors (1) auf Basis eines magnetfeldsensitiven Effekts in einer zur Strommessung abgetasteten Stromschiene oder Leiterschleife (2), umfassend die Schritte:

A. Bereitstellen einer zu der vom Stromsensor (1) magnetfeldsensitiv abgetasteten Stromschiene oder Leiterschleife (2) benachbart angeordneten, zusätzlichen abtastbaren Testleiterschleife (3) zum Aufprägen eines modulierten Teststroms ($I_T$),
B. Erfassen von ersten Messwerten mittels des Stromsensors (1) zur sukzessiven Strommessung und -überwachung in einem vorgegebenen Messbereich (12) der abgetasteten Stromschiene oder Leiterschleife (2),
C. Erzeugen eines impulsmodulierten Teststromes ($I_T$) mittels eines Teststromgenerators (4),
D. zeitlich begrenztes Einleiten des modulierten Teststromes ($I_T$) in die Testleiterschleife (3),
E. Erfassen von mindestens einem zweiten Messwert durch Strommessung mittels des Stromsensors (1) bei Überlagerung von Magnetfeldern des Teststromes ($I_T$) in der Testleiterschleife (3) und des Stroms in der vom Stromsensor (1) magnetfeldsensitiv abgetasteten Stromschiene oder Leiterschleife (2),
F. Bestimmen eines Differenzstromes ($I_D$) aus ersten und zweiten Messwerten und Auswerten des Differenzstromes ($I_D$) zum Erkennen von Abweichungen des Differenzstromes ($I_D$) von einem eingeleiteten Signalverlauf des Teststromes ($I_T$).

13. Verfahren nach Anspruch 12, **dadurch gekennzeichnet, dass** der Teststrom ($I_T$) als Einzelimpuls oder als definierte Impulssequenz bereitgestellt wird.

14. Verfahren nach Anspruch 12 oder 13, **dadurch gekennzeichnet, dass** der Teststrom ($I_T$) als Rechteck-, Sägezahn- oder Sinusimpuls oder in einer Impulssequenz daraus als Wiederkehr gleicher oder unterschiedlicher Impulse bereitgestellt wird.

15. Verfahren nach Anspruch 13 oder 14, **dadurch gekennzeichnet, dass** der Teststrom ($I_T$) als frei definierte Impulssequenz bereitgestellt wird, die zur Auswertung vorzugsweise mit Mustererkennungsalgorithmen angelernt werden kann.

**Fig. 1**

**Fig. 1A**

**Fig. 2**

**Fig. 3**

**Fig. 3A**

**Fig. 3B**

**Fig. 3C**

**Fig. 3D**

**Fig. 4**

Fig. 5

**Fig. 6**

EP 4 439 088 A1

**Fig. 7**

Europäisches
Patentamt

European
Patent Office

Office européen
des brevets

# EUROPÄISCHER RECHERCHENBERICHT

Nummer der Anmeldung

EP 24 16 6201

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2009 054943 A1 (SB LIMOTIVE CO LTD [KR]; SB LIMOTIVE GERMANY GMBH [DE]) 22. Juni 2011 (2011-06-22) * Absatz [0004] - Absatz [0022]; Abbildungen 1-3 * - - - - - | 1-3,8,9, 11-15 | INV. G01R15/20 G01R35/00 |
| X | DE 10 2015 103162 A1 (INFINEON TECHNOLOGIES AG [DE]) 10. September 2015 (2015-09-10) * Absatz [0038] - Absatz [0060]; Anspruch 1; Abbildungen 1-6 * - - - - - | 1,4-7,12 | |
| X | DE 10 2012 221803 A1 (INFINEON TECHNOLOGIES AG [DE]) 29. Mai 2013 (2013-05-29) * Absatz [0025] - Absatz [0108]; Abbildungen 1-11 * - - - - - | 1,10 | |

RECHERCHIERTE
SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 11. Juli 2024 | Sedlmaier, Stefan |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 16 6201

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-07-2024

| Im Recherchenbericht angeführtes Patentdokument | Datum der Veröffentlichung | Mitglied(er) der Patentfamilie | Datum der Veröffentlichung |
|---|---|---|---|
| DE 102009054943 A1 | 22-06-2011 | CN 102656467 A | 05-09-2012 |
| | | DE 102009054943 A1 | 22-06-2011 |
| | | EP 2513655 A1 | 24-10-2012 |
| | | JP 2013513808 A | 22-04-2013 |
| | | KR 20120093444 A | 22-08-2012 |
| | | US 2012319473 A1 | 20-12-2012 |
| | | WO 2011072934 A1 | 23-06-2011 |
| DE 102015103162 A1 | 10-09-2015 | CN 104897942 A | 09-09-2015 |
| | | DE 102015103162 A1 | 10-09-2015 |
| | | US 2015253412 A1 | 10-09-2015 |
| | | US 2017074961 A1 | 16-03-2017 |
| DE 102012221803 A1 | 29-05-2013 | CN 103134974 A | 05-06-2013 |
| | | DE 102012221803 A1 | 29-05-2013 |
| | | US 2013138372 A1 | 30-05-2013 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012215946 A1
- US 20120319473 A1
- WO 2006042839 A1
- EP 1327891 B1